# FASCICULE DE BREVET EUROPEEN

(11) **EP 0 795 954 B1**
(45) Date de publication et mention de la délivrance du brevet: **12.06.2002**
(21) Numéro de dépôt: 97200727.2
(22) Date de dépôt: 11.03.1997
(51) Int. Cl.: H03D 7/14

(54) **Dispositif incluant un mélangeur en anneau**
Vorrichtung mit einem Ring-Mischer
Apparatus comprising a ring mixer

(30) Priorité: 13.03.1996 FR 9603154
(43) Date de publication de la demande: 17.09.1997
(73) Titulaire: Koninklijke Philips Electronics N.V., 5621 BA Eindhoven (NL)
(72) Inventeur: Puechberty, Eric, 75008 Paris (FR); Jean, Patrick, 75008 Paris (FR); Boyavalle, Christophe, 75008 Paris (FR)
(74) Mandataire: Lottin, Claudine

(56) Documents cités:
- EP-A- 0 223 287
- DE-A- 4 205 486
- US-A- 5 023 576
- US-A- 5 060 298
- PATENT ABSTRACTS OF JAPAN vol. 009, no. 118 (E-316) [1841] , 23 Mai 1985 & JP 60 007210 A (MATSUSHITA DENKI SANGYO KK), 16 Janvier 1985,

## Description

L'invention concerne un dispositif pour mélanger un signal d'entrée à une première fréquence RF avec un signal d'entrée provenant d'un oscillateur local à une seconde fréquence LO, et pour fournir un signal de sortie à une fréquence intermédiaire IF, avec réjection des harmoniques de la seconde fréquence LO jusqu'à un ordre très élevé, par exemple supérieur à 10, ce circuit comprenant un mélangeur en anneau à transistors à effet de champ doublement équilibré.

L'invention trouve son application dans l'industrie des circuits intégrés pour le domaine des télécommunications, et tout particulièrement dans l'industrie des circuits hyperfréquences monolithiquement intégrés (MMICs).

Un dispositif incluant un mélangeur doublement équilibré et monolithiquement intégré ayant un point d'interception du troisième ordre à un niveau élevé est déjà connu de l'état de la technique par le brevet US 5060298 (Référence WAUGH du 22 octobre 1991).

Ce document décrit un mélangeur hyperfréquences qui convertit une fréquence RF d'un signal d'entrée en une fréquence IF intermédiaire d'un signal de sortie en effectuant l'addition entre la fréquence RF dudit signal d'entrée et la fréquence LO d'un signal fourni par un oscillateur local.

Pour réaliser le mélangeur lui-même, quatre transistors à effet de champ, sans polarisation drain-source, sont organisés en anneaux. Les transistors sont montés de telle sorte qu'une source d'un transistor est connectée à la source du transistor adjacent d'un côté, et que le drain dudit transistor est connecté au drain du transistor adjacent de l'autre côté. Les grilles des transistors non adjacents sont couplées par deux.

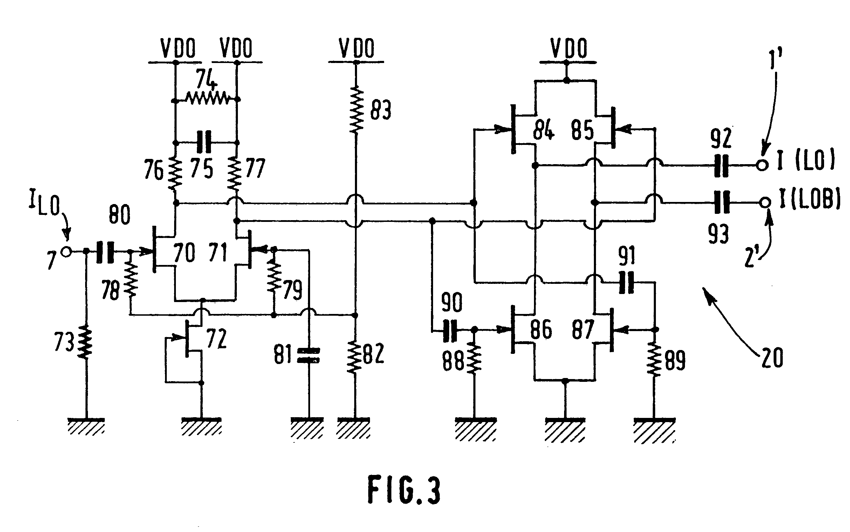

Le mélangeur comprend aussi un circuit transformateur d'impédance (BALUN), un circuit combineur de fréquences (COMBINER) et un circuit séparateur de phase (PHASE SPLITTER). Le circuit transformateur d'impédance comprend au minimum six étages distribués à transistors à effet de champ, et est appliqué au signal provenant de l'oscillateur local pour fournir deux signaux à la fréquence LO, en opposition de phase, appliqués aux grilles couplées des transistors du mélangeur en anneau. Il est important de noter que ce circuit transformateur d'impédance ne présente pas d'impédances identiques sur les deux bornes de sortie en opposition de phase vis-à-vis de la masse respectivement (FIG.3 du document). Le circuit combineur comporte deux étages distribués et est appliqué aux sources couplées du mélangeur en anneau pour recombiner les signaux de sortie à la fréquence intermédiaire IF en opposition de phase. Il est important de noter que pour recombiner le signal IF et son complémentaire, ce circuit ne peut pas présenter des mêmes impédances sur ses deux bornes d'entrée, sinon le signal recombiné serait nul. Le circuit séparateur de phases comporte un étage à transistor double grille et fournit, à partir d'un signal d'entrée à la fréquence RF, deux signaux à la fréquence RF en opposition de phase pour appliquer aux drains couplés du mélangeur en anneau. De même que les autres circuits appliqués au mélangeur, ce circuit séparateur de phases ne peut pas présenter des impédances identiques sur ses bornes de sorties vis-à-vis de la masse respectivement, sinon les signaux de sortie seraient nuls.

Ce dispositif connu a pour objet de fournir un point d'interception IP3 de niveau supérieur à 30dBm. Pour atteindre le but fixé, ce circuit mélangeur est doublement équilibré c'est-à-dire reçoit, sur les deux bornes formées de drains couplés des transistors, des signaux en opposition de phase, et fournit, sur les deux bornes formées des sources couplées des transistors, des signaux en opposition de phase ; de même les grilles des transistors couplées en croix deux à deux reçoivent des signaux en opposition de phase. Les signaux aux fréquences RF et Lo sont dans un domaine de fréquences serré entre 8,5 à 10,5 Ghz pour produire un signal à la fréquence intermédiaire éloignée IF de 0,5 à 2 Mhz.

Le dispositif connu du document cité ne s'intéresse qu'à l'harmonique 3. D'une manière générale, l'homme du métier sait que la valeur du point d'interception IP3 dépend pour la majeure partie du mélangeur en anneau, et que, dès lors que des transistors à effet de champ sont utilisés pour réaliser le mélangeur en anneau, la valeur de ce point d'interception est assez élevée. Cette valeur dépend aussi des rapports de transformation des transformateurs d'impédance.

Un problème technique se pose lorsque le signal d'entrée à la fréquence RF et le signal de sortie à la fréquence intermédiaire IF sont dans un domaine de fréquences très resserré, au lieu du signal à la fréquence RF et du signal à la fréquence de l'oscillateur local comme dans le document cité. Pour produire un signal à la fréquence intermédiaire IF substantiellement proche de la fréquence RF du signal d'entée, le signal de l'oscillateur local doit alors être à une fréquence LO notablement plus basse que celle du signal à la fréquence RF, de manière à obtenir le mélange de fréquences voulu.

L'homme du métier sait que dans un système de mélangeur quelconque, des harmoniques sont toujours obtenues. Lorsque le signal de l'oscillateur local est à une fréquence plus basse et très différente de celle des signaux d'entrée et de sortie aux fréquences RF et IF qui sont d'une part beaucoup plus élevées et d'autre part peu différentes entre elles, alors, il en résulte que des harmoniques d'ordre élevé, par exemple des harmoniques d'ordre 10 ou 11 du signal à la fréquence LO de l'oscillateur local se trouvent dans le domaine de fréquences resserré des signaux d'entrée et de sortie aux fréquences RF et IF respectivement.

L'élimination des harmoniques de la fréquence LO de l'oscillateur local, allant au moins jusqu'à l'ordre 10, est donc un problème différent du problème traité par le document cité. Ce problème ne peut être résolu que par des moyens spécifiques.

Un autre problème se pose à ce jour, dû à la demande du marché et à l'état de la concurrence, consistant dans le fait que seuls les circuits les moins consommateurs d'énergie trouvent preneur. De ce point de vue, le dispositif connu du document cité est défavorable, car très consommateur du fait que les circuits appliqués au mélangeurs sont des circuits actifs incluant de nombreux étages à transistors.

Selon l'invention ces problèmes sont résolus par un dispositif pour mélanger un signal d'entrée à une première fréquence RF avec un signal d'entrée provenant d'un oscillateur local à une seconde fréquence LO, et pour fournir un signal de sortie à une fréquence intermédiaire IF, avec réjection des harmoniques de la seconde fréquence LO jusqu'à un ordre très élevé, par exemple supérieur à 10, ce dispositif comprenant :
un mélangeur en anneau à transistors à effet de champ doublement équilibré, ayant une première et une seconde paires de bornes d'entrées et ayant une paire de bornes de sorties,
un premier et un second coupleurs respectivement séparateur et combineur de phase pour ledit signal d'entrée à la première fréquence RF et le signal de sortie à la fréquence intermédiaire IF, connectés respectivement à la première paire de bornes d'entrée et à la paire de bornes de sortie du mélangeur en anneau,
dispositif dans lequel le premier et le second coupleurs sont constitués chacun respectivement d'un premier et d'un second sous-circuits déphaseurs passifs identiques formés d'éléments localisés, et montés symétriquement, de manière que les impédances respectives sur les bornes de la première paire d'entrées et sur les bornes de la paire de sorties du mélangeur sont identiques.

Un avantage de ce dispositif est que les bornes diamétralement opposées du mélangeur en anneau voient des impédances exactement identiques sur une bande de fréquences très large, d'où il résulte que ce mélangeur rejette les harmoniques d'un ordre très élevé, par exemple d'ordre supérieur à 10, du signal de l'oscillateur local, lorsque les fréquences des signaux d'entrée et sortie RF et IF sont dans le domaine de fréquences resserré d'environ 11 à 14.5 Ghz et la fréquence de l'oscillateur local est de l'ordre de 1 à 3 Ghz.

Un autre avantage de ce dispositif réside dans une très faible consommation du mélangeur et des coupleurs, ce qui est particulièrement favorable actuellement, cette consommation étant par exemple inférieure à 500 mW.

Les FIGs schématiques illustrant un dispositif selon l'invention sont décrites ci-après de façon succinctes :
La FIG.1A représente un dispositif comprenant un mélangeur en anneau à transistors à effet de champ auquel sont appliqués un coupleur symétrique et un amplificateur pour les entrées, et un coupleur symétrique pour les sorties ;
La FIG.1B représente le dispositif de la FIG.1A avec le montage symétrique des coupleurs ;
La FIG.2A représente le dispositif de la FIG.1A avec, en détail, un coupleur symétrique pour le signal d'entrée à la fréquence RF ;
La FIG.2B représente le dispositif de la FIG.1A avec, en détail, un coupleur symétrique pour le signal de sortie à la fréquence intermédiaire IF ;
La FIG.3 représente un amplificateur pour le signal à la fréquence LO de l'oscillateur local.

Le dispositif est décrit ci-après en détail dans un mode de réalisation préférentiel à titre non limitatif.

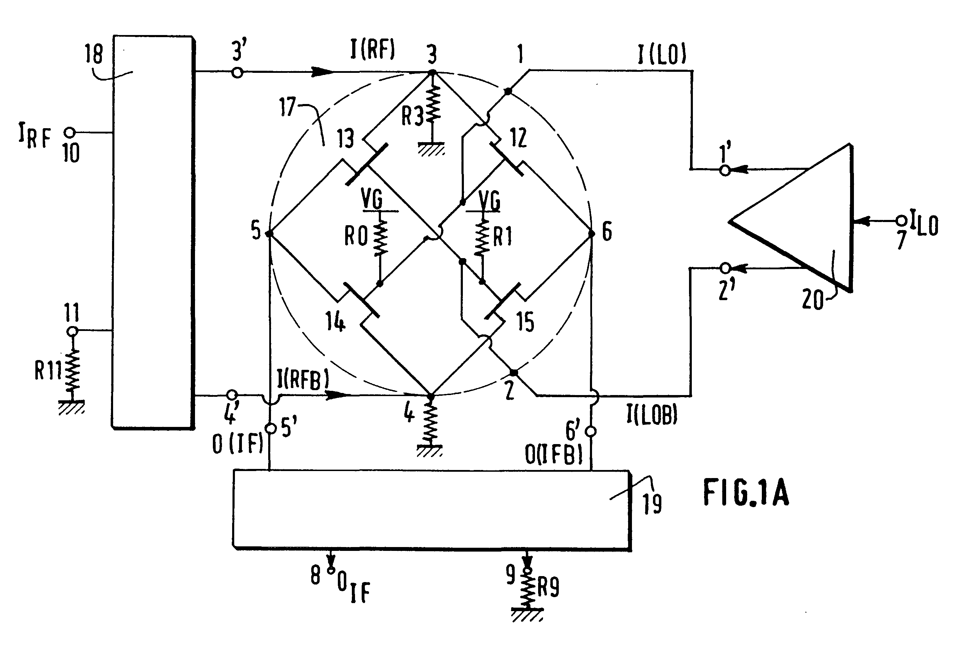

La FIG.1A représente un dispositif pour mélanger un signal d'entrée I_{RF} à une première fréquence RF avec un signal d'entrée I_{LO} à la seconde fréquence LO d'un oscillateur local non représenté, et pour fournir un signal de sortie O_{IF} à une fréquence intermédiaire IF, avec réjection des harmoniques de la fréquence LO de l'oscillateur local jusqu'à un ordre élevé. Ce dispositif comprend :
un mélangeur en anneau 17 à transistors à effet de champ 12,13,14,15 doublement équilibré, ayant une première paire d'entrées 3,4 pour un premier signal I(RF) à la première fréquence RF et son complémentaire I(RFB), ayant une paire de sorties 5,6 pour un second signal O(IF) à la fréquence intermédiaire IF et son complémentaire O(IFB), et ayant une seconde paire d'entrées 1,2 pour un troisième signal I(LO) à la fréquence LO de l'oscillateur local et son complémentaire I(LOB),
un premier coupleur 18 ayant une borne d'entrée appelée externe 10 pour le signal d'entrée I_{RF} à la première fréquence RF, et une paire de bornes de sortie appelées internes 3' et 4' pour ledit premier signal et son complémentaire I(RF) et I(RFB) qui sont connectées aux bornes de la première paire d'entrées 3 et 4 du mélangeur en anneau 17,
un second coupleur 19 ayant deux bornes d'entrée appelées internes 5' et 6' pour le second signal 0(IF) et son complémentaire O(IFB) connectées aux bornes de la paire de sorties 5,6 du mélangeur en anneau 17, et une borne de sortie appelée externe 8 pour ledit signal de sortie O_{IF} à la fréquence intermédiaire IF,
un troisième coupleur 20 ayant une borne d'entrée appelée externe 7 pour le signal d'entrée I_{LO} provenant d'un oscillateur local, et une paire de bornes de sortie appelées internes 1' et 2' pour ledit troisième signal I(LO) et son complémentaire I(LOB) qui sont connectées aux bornes de la seconde paire d'entrées 1 et 2 du mélangeur en anneau 17.

Les signaux en entrée et en sortie des coupleurs sont référencés de manière respectivement différente parce que lesdits coupleurs peuvent déphaser dans une certaine mesure les signaux présents sur les bornes internes vis-à-vis des signaux présents sur les bornes externes.

Le circuit mélangeur en anneau 17 comprend quatre transistors à effet de champ 12,13,14,15 ayant chacun des électrodes de grille, drain et source, montés en anneau avec :
les drains des transistors adjacents 12 et 13 d'une part, et 14 et 15 d'autre part, couplés par deux pour former la première paire de bornes d'entrée 3,4,
les grilles des transistors non adjacents 13 et 15 d'une part, et 12 et 14 d'autre part, couplées par deux en croix pour fournir la seconde paire de bornes d'entrée 1,2,
et les sources des transistors adjacents 13 et 14 d'une part, et 15 et 12 d'autre part, couplées par deux pour former la paire de bornes de sortie 5,6.

Ce circuit mélangeur en anneau comprend en outre des moyens de polarisation en continu grille-drain des transistors. Ces moyens de polarisation comprennent :
l'application d'une tension de polarisation VG à travers une résistance R0 sur les grilles couplées des transistors 12 et 14,
l'application d'une tension de polarisation VG à travers une résistance R1 sur les grilles couplées des transistors 13 et 15,
la connexion des drains couplés 3 des transistors 12 et 13 à la masse à travers une résistance R3,
la connexion des drains couplés 4 des transistors 14 et 15 à la masse à travers une résistance R4.

Les transistors à effet de champ peuvent être du type MESFET, ou mieux, du type MOSFET.

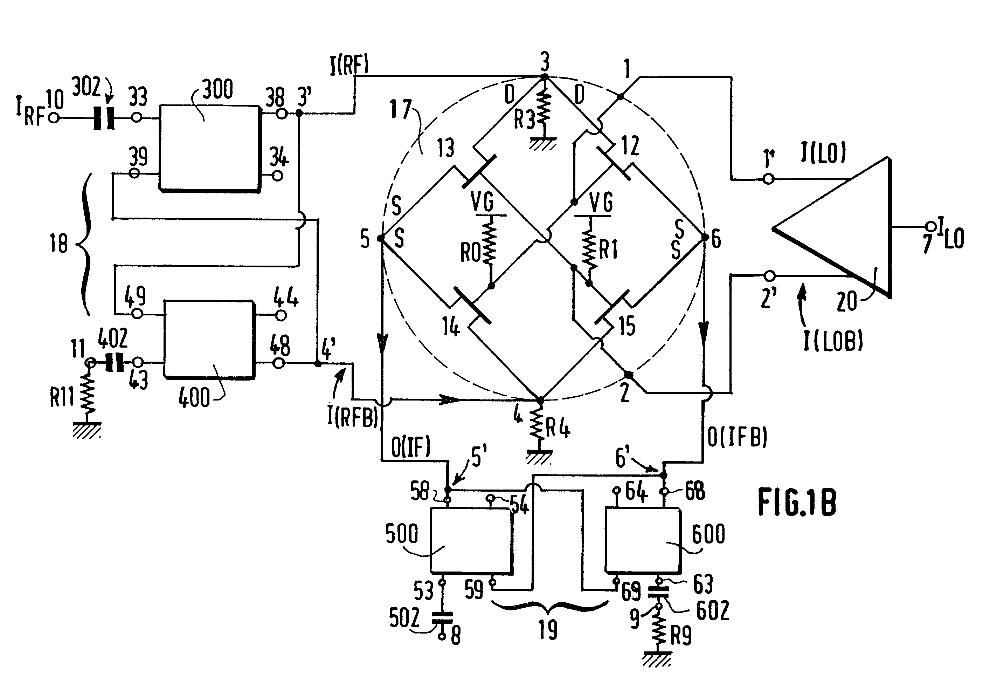

En référence avec la FIG.1B, dans ce circuit, le premier et le second coupleurs 18,19 sont constituées chacun de deux sous-circuits déphaseurs passifs identiques formés d'éléments localisés, référencés respectivement 300 et 400 pour le premier coupleur 18, et 500 et 600 pour le second coupleur 19 et montés symétriquement, de manière que, pour le premier et le second coupleur indépendamment, les impédances sur lesdites première et seconde bornes internes sont identiques vis-à-vis de la masse. Il en résulte que la borne d'entrée 3 et la borne d'entrée 4 du mélangeur en anneau 17 voient exactement la même impédance vis-à-vis de la masse, et la borne de sortie 5 et la borne de sortie 6 du mélangeur en anneau 17 voient exactement la même impédance vis-à-vis de la masse. Le premier et le second coupleurs 18,19 sont appelés coupleurs symétriques.

Dans le premier coupleur 18 symétrique, le premier sous-circuit 300 et le second sous-circuit 400 ont chacun une première et une seconde bornes externes respectivement 33, 39 et 43, 49, et ont chacun respectivement une première et une seconde bornes internes respectivement 38, 34 et 48, 44. Les deux sous-circuits 300,400 sont montés symétriquement. A cet effet, la première borne externe 33 du premier sous-circuit 300 est connectée à la borne externe 10 du coupleur correspondant 18, où est appliqué le signal d'entrée I_{RF} à la première fréquence RF, et la première borne externe 43 du second sous-circuit 400 est connectée à une charge R11 correspondant à la valeur de l'impédance du générateur dudit signal d'entrée à la première fréquence RF. Les secondes bornes externes, respectivement 39 et 49, du premier et du second sous-circuits sont couplées en croix aux premières bornes internes respectivement 48 et 38 du second et du premier sous-circuits. Ces points de couplage constituent les bornes internes 3',4' du coupleur correspondant 18. Les secondes bornes internes, respectivement 34 et 44 du premier et du second sous-circuit sont en l'air.

Dans le second coupleur 19 symétrique, le premier sous-circuit 500 et le second sous-circuit 600 ont chacun une première et une seconde bornes externes respectivement 53, 59 et 63, 69, et ont chacun respectivement une première et une seconde bornes internes respectivement 58, 54 et 68, 64. Les deux sous-circuits 500,600 sont montés symétriquement. A cet effet, la première borne externe 53 du premier sous-circuit 500 est connectée à la borne externe 8 du coupleur correspondant 19, où est disponible le signal de sortie O_{IF}, à la fréquence intermédiaire IF, et la première borne externe 63 du second sous-circuit 600 est connectée à une charge R9 correspondant à la valeur de l'impédance de sortie. Les secondes bornes externes, respectivement 59 et 69, du premier et du second sous-circuits sont couplées en croix aux premières bornes internes respectivement 68 et 58 du second et du premier sous-circuits. Ces points de couplage constituent les bornes internes 5' et 6' du coupleur correspondant 19. Les secondes bornes internes, respectivement 54 et 64 du premier et du second sous-circuits sont en l'air.

Le signal présent sur la seconde borne externe (39,49) de chaque sous-circuit du premier coupleur 18 est déphasé de 180° par rapport au signal présent sur la première borne interne (38,48), en sorte que les signaux présents sur les bornes internes du premier coupleur 18 sont déphasés de 180°.

Le premier coupleur 18 a une fonction de séparateur de phase puisqu'il fournit deux signaux I(RF) et I(RFB) en opposition de phase, à partir du signal d'entrée I_{RF} à la fréquence d'entrée RF.

Le signal présent sur la seconde borne externe (59,69) de chaque sous-circuits du second coupleur 19 est déphasé de 180° par rapport au signal présent sur la première borne interne (58,68), les signaux O(IF) et O(IFB) présents sur les bornes internes 5', 6' du second coupleur 19 étant déphasés de 180°.

Le second coupleur 19 a donc une fonction de combineur puisqu'il fournit le signal de sortie O_{IF} à la fréquence intermédiaire à partir des deux signaux O(IF) et O(IFB) en opposition de phase.

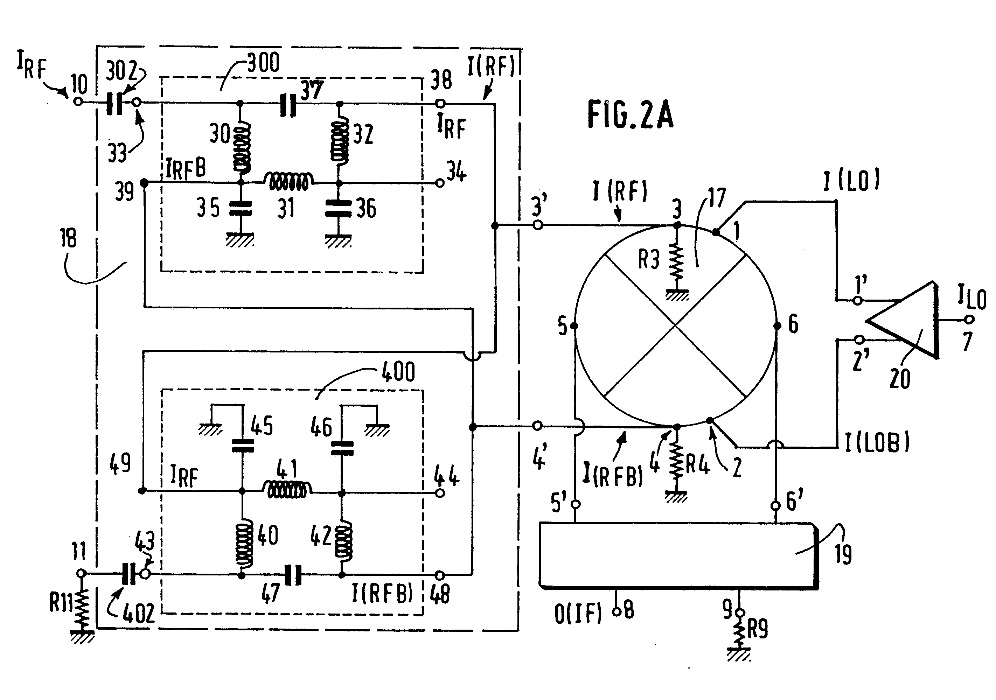

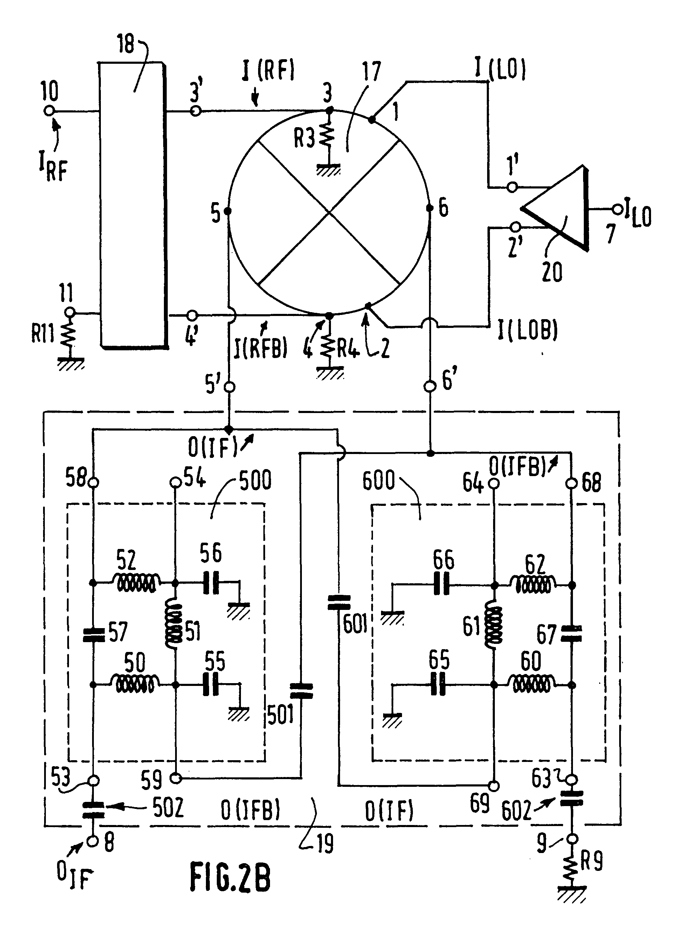

En référence avec les FIG.2A et FIG.2B, chaque sous-circuit déphaseur passif 300, 400, 500, 600 est constitué :
d'une capacité 37, 47, 57 67, montée entre la première borne externe 33, 43, 53, 63 et la première borne interne 38, 48, 58, 68,
d'une inductance 30, 40, 50, 60 montée entre la première borne externe et la seconde borne externe 39, 49, 59, 69,
d'une capacité 35, 45, 55, 65 entre la seconde borne externe et la masse,
d'une inductance 31, 41, 51, 61 entre la seconde borne externe et la seconde borne interne 34, 44, 54, 64,
d'une inductance 32, 42, 52, 62 entre la seconde borne interne et la première borne interne,
avec une capacité 36, 46, 56, 66 entre la seconde borne interne et la masse.

Les valeurs des éléments localisés constituant le premier et le second sous-circuits du premier coupleur 18 sont respectivement exactement identiques. Les valeurs des éléments localisés constituant le premier et le second sous-circuits du second coupleur 19 sont respectivement exactement identiques.

En référence avec la FIG.3 le troisième coupleur 20 inclut favorablement un étage amplificateur différentiel et un étage tampon.

L'étage amplificateur différentiel comprend deux transistors à effet de champ 70 et 71 couplés par leurs sources communes au drain d'un transistor 72 monté en source de courant avec sa source et sa grille réunies à la masse. Les drains des transistors différentiels sont polarisés par une tension de polarisation VDD à travers une résistance, respectivement 76 et 77. Les points de connexion de ces résistances 76 et 77 à ses bornes distribuant la tension de polarisation VDD sont couplés par une résistance 74 et une capacité 75 en parallèle. Le signal d'entrée I_{LO} provenant de l'oscillateur local est appliqué sur la grille du premier et du second transistors différentiels 70,71 sur une impédance 73 reliée à la grille du premier transistor différentiel 70 et à la masse, la grille du second transistor différentiel 71 étant par ailleurs reliée à la masse. Les grilles des deux transistors différentiels 70,71 sont polarisées par un montage comprenant deux résistances en parallèle 78 et 79 dont le point de couplage est connecté à la tension de polarisation VDD à travers une résistance 83, et est connecté à la masse à travers une résistance 82.

L'étage tampon comprend une première paire de transistors à effet de champ avec un transistor bas 86 et un transistor haut 84 montés en série entre la masse et une borne pour la tension de polarisation VDD, et une deuxième paire de transistors à effet de champ avec un transistor bas 87 et un transistor haut 85 montés en série entre la masse et une borne pour la tension de polarisation VDD. Les drains des transistors différentiels 70,71 sont connectés directement avec les grilles des transistors hauts 84 et 85 de la première et de la seconde paire de transistors de l'étage tampon respectivement, et sont connectés directement avec les grilles des transistors bas 87 et 86 de la seconde et de la première paire de transistors respectivement de cet étage tampon. Les grilles des transistors bas sont en outre polarisées par rapport à la masse au moyen de résistances 88 et 89.

Les troisièmes signaux I(OL) et I(OLB) en opposition de phase à la fréquence de l'oscillateur local sont disponibles aux bornes 1' et 2', aux points communs des transistors hauts et bas. Grâce à ce montage symétrique des étages différentiels et tampons, le mélangeur en anneau 17 voit des impédances identiques vis-à-vis de la masse sur ses secondes bornes d'entrée 1 et 2.

A titre d'exemple un dispositif comme décrit plus haut a été réalisé avec les spécifications suivantes :

| | |
|---|---|
| Fréquence d'entrée RF | 13 - 14,5 GHz |
| Fréquence de sortie IF | 10,95 - 12,75 GHz |
| Fréquence OL | 1,25 - 3,3 GHz |
| Consommation | < 500 mW |

Dans le premier coupleur (18)
R11 = 50 Ω
Les inductances (30,31,32) = 1nH chacune
Les inductances (40,41,42) = 1nH chacune
Les capacités (37,47) ≃ 0,1 pF chacune
Les capacités (35,36 ; 45,46) ≃ 1 pF chacune
Dans le second coupleur (19)
R9 = 50 Ω
Les inductances (50,51,52) = 1nH chacune
Les inductances (60,61,62) = 1nH chacune
Les capacités (57,67) ≃ 0,1 pF chacune
Les capacités (55,56 ; 65,66) = ≃ 0,1 pF chacune

Les capacités d'isolation en continu ont pour valeur environ 3 pF.

Dans le mélangeur
VG = -1V

Les résistances R3 = R4 = 5kΩ.

La largeur de grille des transistors MESFET = 140 µm chacune.
Dans le troisième coupleur VDD = 8V

Les largeurs de grille des transistors de l'étage différentiel = 180 µm.

Les largeurs de grille des transistors de l'étage tampon = 70 µm.

Les résistances (76,77) = 260 Ω chacune

Les résistances (78,79) = 7 kΩ chacune

Les résistances (88,89) = 10 kΩ chacune.

Un dispositif tel que décrit plus haut a été intégré sur un substrat du groupe chimique III-V, favorablement de l'arséniure de gallium (GaAs) pour former un circuit semiconducteur du type hyperfréquences monolithiquement intégré (MMIC).

Un dispositif tel que décrit plus haut a été utilisé dans un appareil convertisseur de fréquences. Il peut être également favorablement utilisé dans un appareil émetteur et/ou récepteur pour télécommunication. Ce dispositif peut être utilisé par exemple dans les transmissions par satellite, ou par exemple dans les transmissions par faisceaux hertziens qui sont des liaisons en hautes fréquences pour le téléphone, la télévision, etc.

## Revendications

1. Dispositif pour mélanger un signal d'entrée (I_{RF}) à une première fréquence (RF) avec un signal d'entrée (I_{LO}) provenant d'un oscillateur local à une seconde fréquence (LO), et pour fournir un signal de sortie (O_{IF}) à une fréquence intermédiaire (IF), avec réjection des harmoniques de la seconde fréquence (LO) jusqu'à un ordre très élevé par exemple supérieur à 10, ce circuit comprenant :
un mélangeur en anneau (17) à transistors à effet de champ (12,13,14,15) doublement équilibré, ayant une première et une seconde paires de bornes d'entrées (3,4;1,2) et ayant une paire de bornes de sorties (5,6),
un premier et un second coupleurs (18,19) respectivement séparateur et combineur de phase, pour ledit signal d'entrée (I_{RF}) à la première fréquence (RF) et le signal de sortie (O_{IF}) à la fréquence intermédiaire (IF), connectées respectivement à la première paire de bornes d'entrée (3,4) et à la paire de bornes de sortie (5,6) du mélangeur en anneau (17),
dispositif dans lequel le premier et le second coupleurs (18,19) sont constituées chacun respectivement d'un premier et d'un second sous-circuits (300,400;500,600) déphaseurs passifs identiques formés d'éléments localisés, et montés symétriquement, de manière que les impédances respectives sur les bornes de la première paire d'entrée et les bornes de la paire de sortie du mélangeur sont identiques.

2. Dispositif selon la revendication 1, dans lequel,
le premier et le second coupleurs (18,19) ont chacun une borne appelée externe (10,8) pour respectivement ledit signal d'entrée (I_{RF}) à la première fréquence (RF) et le signal de sortie (O_{IF}) à la fréquence intermédiaire (IF), et une paire de bornes appelées internes (3',4' ; 5',6') pour respectivement des premiers signaux en opposition de phase à la fréquence dudit signal d'entrée (I(RF), I(RFB)), et des seconds signaux en opposition de phase (I(IF), I(IFB)) à la fréquence du signal de sortie, et sont connectés respectivement à la première paire de bornes d'entrée (3,4) et à la paire de bornes de sortie (5,6) du mélangeur en anneau (17),
et dans lequel, dans le premier et le second coupleurs (18,19), les premier et second sous-circuits ont chacun une première et une seconde bornes externes, et une première et une seconde bornes internes, et sont montés symétriquement avec la première borne externe (33,53) du premier sous-circuit (300,500) connectée à la borne externe (10,8) du coupleur correspondant (18,19), et la première borne externe (43,63) du second sous-circuit (400,600) connectée à une charge (R11,R9), et avec la seconde borne externe (39,49;59,69) de chaque sous-circuit couplée en croix avec la première borne interne (38,48;58,68) du sous-circuit symétrique, ces bornes couplées étant connectées respectivement à la première et à la seconde bornes internes (3',4';5',6') du coupleur correspondant (18,19).

3. Dispositif selon la revendication 2, dans lequel chaque sous-circuit déphaseur passif est constitué :
d'une capacité (37,47;57,67) montée entre la première borne externe (33,43;53,63) et la première borne interne (38,48;58,68), d'une inductance (30,40;50,60) montée entre ladite première borne externe et la seconde borne externe (39,49;59,69), d'une capacité (35,45;55,65) entre ladite seconde borne externe et la masse, d'une inductance (31,41;51,61) entre la seconde borne externe et la seconde borne interne (34,44;54,64), et d'une inductance (32,42;52,62) entre ladite seconde et ladite première bornes internes, avec une capacité (36,46;56,66) entre ladite seconde borne interne et la masse.

4. Dispositif selon la revendication 3, dans lequel le circuit mélangeur en anneau (17) comprend quatre transistors à effet de champ (12,13,14,15) ayant chacun des électrodes de grille, drain et source, montés en anneau avec les drains des transistors adjacents couplés pour former la première paire de bornes d'entrée (3,4), les sources des transistors adjacents couplées pour former la paire de bornes de sortie (5,6), et les grilles des transistors non adjacents couplées par deux en croix pour fournir la seconde paire de bornes d'entrée (1,2), ce circuit mélangeur en anneau comprenant en outre des moyens de polarisation en continu (VG,R3;VG,R4) grille-drain des transistors.

5. Dispositif selon la revendication 4, comprenant un troisième coupleur (20) ayant une borne appelée externe (7) pour ledit signal d'entrée (I_{LO}) à la fréquence de l'oscillateur local, et une paire de bornes appelées internes (1',2') pour un troisième signal et son complémentaire (I(LO),I(LOB)) à la fréquence dudit signal de l'oscillateur local, connectés à la seconde paire de bornes d'entrée (1,2) du mélangeur en anneau (17), dans lequel les impédances sur lesdits première et seconde bornes internes sont identiques vis-à-vis de la masse.

6. Dispositif selon la revendication 5, dans lequel le troisième coupleur comprend un étage amplificateur différentiel à transistors à effet de champ qui reçoit sur la borne externe (7) le signal d'entrée I_{LO} à la fréquence (LO) de l'oscillateur local, et un étage tampon symétrique à transistors à effet de champ sortant sur les bornes internes (1',2') avec des impédances identiques symétriques vis-à-vis de la masse .

7. Dispositif selon l'une des revendications 1 à 6, dans lequel les transistors à effet de champ du mélangeur (17) sont du type MESFET.

8. Dispositif selon l'une des revendications 1 à 6, dans lequel les transistors à effet de champ du mélangeur (17) sont du type MOSFET.

9. Dispositif selon l'une des revendications 1 à 8, qui est monolithiquement intégré sur un substrat semiconducteur ou semi-isolant d'un matériau du groupe III-IV, pour un fonctionnement en hyperfréquences (MMIC).

10. Dispositif selon la revendication 9, pour un fonctionnement avec un signal d'entrée (I_{RF}) et un signal de sortie (O_{IF}) à des fréquences proches qui sont environ cinq à quinze fois la valeur de la fréquence du signal (I_{LO}) de l'oscillateur local.

11. Appareil convertisseur de fréquences incluant un dispositif selon l'une des revendications 1 à 10.

12. Appareil émetteur et/ou récepteur incluant un dispositif selon l'une des revendications 1 à 10.

13. Appareil selon la revendication 12, pour la transmission par faisceaux hertziens.

## Patentansprüche

1. Vorrichtung zum Mischen eines Eingangssignals (I_{RF}) mit einer ersten Frequenz (RF) mit einem Eingangssignal (I_{LO}) aus einem Empfangsoszillator mit einer zweiten Frequenz (LO), und zum Abgeben eines Ausgangssignals (O_{IF}) mit einer Zwischenfrequenz (IF), mit Unterdrückung der Oberschwingungen der zweiten Frequenz (LO) bis zu einer sehr hohen Größenordnung, z.B. über 10, wobei diese Schaltung enthält:
einen Ring-Mischer (17) mit doppelt getrimmten Feldeffekttransistoren (12, 13, 14, 15) mit einem ersten und einem zweiten Paar Eingangsklemmen (3, 4; 1, 2) und mit einem Paar Ausgangsklemmen (5, 6),
einen ersten und einen zweiten Koppler (18, 19), respektive Phasen-Trenner und Zusammenführer für das besagte Eingangssignal (I_{RF}) mit der ersten Frequenz (RF) und das Ausgangssignal (O_{IF}) mit der Zwischenfrequenz (IF), respektive mit dem ersten Paar Eingangsklemmen (3, 4) und dem Paar Ausgangsklemmen (5, 6) des Ring-Mischers (17) verbunden,
Vorrichtung, in der der erste und der zweite Koppler (18, 19) respektive aus einer ersten und einer zweiten identischen passiven Phasenschieb-Unterschaltung (300, 400; 500, 600) aus georteten Elementen gebildet wird, und symmetrisch geschaltet, damit die Impedanzen respektive an den Klemmen des ersten Eingangspaars und den Klemmen des Ausgangspaars des Mischers identisch sind.

2. Vorrichtung nach Anspruch 1, in der der erste und der zweite Koppler (18, 19) jeweils eine sogenannte externe Klemme (10, 8) aufweisen, für respektive das besagte Eingangssignal (I_{RF}) mit der ersten Frequenz (RF) und das Ausgangssignal (O_{IF}) mit der Zwischenfrequenz (IF), und ein sogenanntes internes Klemmenpaar (3', 4'; 5', 6') für respektive erste Signale in Gegenphasigkeit zu der Frequenz des besagten Eingangssignals (I(RF), I(RFB)) und zweite Signale in Gegenphasigkeit (I(IF), I(IFB)) zur Frequenz des Ausgangssignals, und sie sind respektive mit dem ersten Paar Eingangsklemmen (3, 4) und dem Paar Ausgangsklemmen (5, 6) des Ring-Mischers (17) verbunden,
und in der im ersten und im zweiten Koppler (18, 19) die erste und zweite Unter-Schaltung jeweils eine erste und eine zweite externe Klemme aufweisen, und eine erste und eine zweite interne Klemme, und sie sind symmetrisch mit der ersten externen Klemme (33, 53) der ersten Unter-Schaltung (300, 500) geschaltet, mit der externen Klemme (10, 8) des entsprechenden Kopplers (18, 19) verbunden, und der ersten externen Klemme (43, 63) der zweiten Unter-Schaltung (400, 600), mit einer Ladung (R11, R9) verbunden, und der zweiten externen Klemme (39, 49; 59, 69) jeder Unter-Schaltung, kreuzweise gekoppelt mit der ersten internen Klemme (38, 48; 58, 68) der symmetrischen Unter-Schaltung, wobei diese gekoppelten Klemmen respektive mit der ersten und der zweiten internen Klemme (3', 4'; 5', 6') des entsprechenden Kopplers (18, 19) verbunden sind.

3. Vorrichtung nach Anspruch 2, in der jede passive Phasenschieb-Unter-Schaltung besteht aus:
einer Kapazität (37, 47, 57, 67), zwischen der ersten externen Klemme (33, 43, 53, 63) und der ersten internen Klemme (38, 48, 58, 68) geschaltet, einer Induktanz (30, 40, 50, 60), zwischen der besagten ersten externen Klemme und der zweiten externen Klemme (39, 49, 59, 69) geschaltet, einer Kapazität (35, 45, 55, 65) zwischen der besagten zweiten externen Klemme und der Masse, einer Induktanz (31, 41, 51, 61) zwischen der zweiten externen Klemme und der zweiten internen Klemme (34, 44, 54, 64), und einer Induktanz (32, 42, 52, 62) zwischen der besagten zweiten und der besagten ersten internen Klemme, und mit einer Kapazität (36, 46, 56, 66) zwischen der besagten zweiten internen Klemme und der Masse.

4. Vorrichtung nach Anspruch 3, in der die Ring-Mischer-Schaltung (17) vier Feldeffekttransistoren (12, 13, 14, 15) enthält, mit jeweils Gate-, Drain- und SourceElektroden, im Ring geschaltet, mit den Drains der angrenzenden Transistoren gekoppelt, um das erste Paar Eingangsklemmen (3, 4) zu bilden, den Sources der Angrenzenden Transistoren gekoppelt, um das Paar Ausgangsklemmen (5, 6) zu liefern, und den Gates der nicht angrenzenden Transistoren paarweise über Kreuz gekoppelt, um das zweite Paar Eingangsklemmen (1, 2) zu liefern, wobei diese Schaltung zudem Gate-Drain-Gleichstrom-Polarisierungsverfahren (VG, R3; VG, R4) der Transistoren enthält.

5. Vorrichtung nach Anspruch 4, mit einem dritten Koppler (20) mit einer sogenannten externen Eingangsklemme (7) für das besagte Eingangssignal (I_{LO}) mit der Frequenz des Empfangsoszillators, und einem sogenannten internen Klemmenpaar (1', 2') für ein drittes Signal und seinen Zusatz (I(LO), I(LOB)) mit der Frequenz des besagten Signals des Empfangsoszillators, mit dem zweiten Paar Eingangsklemmen (1, 2) des Ring-Mischers (17) verbunden, in dem die Impedanzen an den besagten ersten und zweiten internen Klemmen angesichts der Masse identisch sind.

6. Vorrichtung nach Anspruch 5, in der der dritte Koppler eine Differential-Verstärkerstufe mit Feldeffekttransistoren enthält, die an der externen Klemme (7) das Eingangssignal I_{LO} mit der Frequenz (LO) des Empfangsoszillators erhält, und eine symmetrische Pufferstufe mit Feldeffekttransistoren, ausgehend an den internen Klemmen (1', 2') mit symmetrischen identischen Impedanzen angesichts der Masse.

7. Vorrichtung nach einem der Ansprüche 1 bis 6, in der die Feldeffekttransistoren des Mischers (17) vom Typ MESFET sind.

8. Vorrichtung nach einem der Ansprüche 1 bis 6, in der die Feldeffekttransistoren des Mischers (17) vom Typ MOSFET sind.

9. Vorrichtung nach einem der Ansprüche 1 bis 8, die auf einem Halbleitersubstrat oder Halbisolator aus einem Material der Gruppe III-IV monolithisch integriert ist, um in Hyperfrequenzen (MMIC) zu arbeiten.

10. Vorrichtung nach Anspruch 9, für einen Betrieb mit einem Eingangssignal (I_{RF}) und einem Ausgangssignal (O_{IF}) mit nahen Frequenzen, die ca. fünf bis fünfzehn mal dem Wert der Frequenz des Signals (I_{LO}) des Empfangsoszillators entsprechen.

11. Frequenz-Wandlungs-Gerät mit einer Vorrichtung nach einem der Ansprüche 1 bis 10.

12. Sende- und/oder Empfangsgerät mit einer Vorrichtung nach einem der Ansprüche 1 bis 10.

13. Gerät nach Anspruch 12 für die Übertragung von Funksignalen.

## Claims

1. A device for mixing an input signal (I_{RF}) having a first frequency (RF) with an input signal (I_{LO}) coming from a local oscillator having a second frequency (LO) and for producing an output signal (O_{IF}) having an intermediate frequency (IF), with rejection of the harmonics of the second frequency (LO) up to a very high order, for example, higher than the tenth order, said device comprising
a ring mixer (17) of double balanced field effect transistors (12, 13, 14, 15), the mixer having a first and a second pair of input terminals (3, 4; 1, 2) and having a pair of output terminals (5, 6), and
a first and a second coupler (18, 19) respectively, comprising a phase splitter and phase combiner for said input signal (I_{RF}) which has the first frequency (RF) and the output signal (O_{IF}) which has the intermediate frequency (IF), connected to the first pair of input terminals (3, 4) and to the pair of output terminals (5, 6) of the ring mixer (17), respectively,
wherein the first and second couplers (18, 19) comprise a first and a second identical passive phase-shifter sub-circuit (300, 400; 500, 600) respectively, formed by isolated elements and symmetrically mounted so that the respective impedances on the terminals of the first input pair and on the terminals of the output pair of the mixer are identical.

2. A device as claimed in Claim 1, in which
the first and the second coupler (18, 19) each have an outside terminal (10, 8) for said input signal (I_{RF}) having the first frequency (RF) and the output signal (O_{IF}) having the intermediate frequency (IF), and a pair of terminals called inside terminals (3', 4'; 5', 6') for the respective first signals in phase opposition having the frequency of said input signal (I(RF), I(RFB)), and second signals (I(IF), I(IFB) in phase opposition) having the frequency of the output signal, and are connected to the first pair of input terminals (3, 4) and to the pair of output terminals (5, 6) of the ring mixer (17), respectively,
and in which device, in the first and the second coupler (18, 19) the first and second sub-circuits each have a first and a second outside terminal and a first and a second inside terminal and are arranged symmetrically with the first outside terminal (33, 53) of the first sub-circuit (300, 500) connected to the outside terminal (10, 8) of the corresponding coupler (18, 19), and the first outside terminal (43, 63) of the second sub-circuit (400, 600) connected to a load (R11, R9), and the second outside terminal (39, 49; 59, 69) of each sub-circuit coupled crosswise with the first inside terminal (38, 48; 58, 68) of the symmetrical sub-circuit, said coupled terminals being connected respectively to the first and second inside terminals (3', 4'; 5', 6') of the corresponding coupler (18, 19).

3. A device as claimed in Claim 2, in which each passive phase shifter sub-circuit is formed by:
a capacitor (37, 47; 57, 67) coupled between the first outside terminal (33, 43; 53, 63) and the first inside terminal (38, 48; 58, 68), an inductor (30, 40; 50, 60) coupled between said first outside terminal and the second outside terminal (39, 49; 59, 69), a capacitor (35, 45; 55, 65) coupled between said second outside terminal and ground, an inductor (31, 41; 51, 61) coupled between the second outside terminal and the second inside terminal (34, 44; 54, 64), and an inductor (32, 42; 52, 62) coupled between said second and said first inside terminals, with a capacitor (36, 46; 56, 66) coupled between said second inside terminal and ground.

4. A device as claimed in Claim 3, in which the ring mixer circuit (17) comprises four field effect transistors (12, 13, 14, 15) each having gate, drain and source electrodes arranged as a ring with the drains of the adjacent transistors coupled for forming the first pair of input terminals (3, 4), the sources of the adjacent transistors coupled for forming the pair of output terminals (5, 6), and the gates of the non-adjacent transistors coupled in pairs crosswise for forming the second pair of input terminals (1, 2), the ring mixer circuit further comprising gate-to-drain DC bias means (VG, R3; VG, R4) of the transistors.

5. A device as claimed in Claim 4, comprising a third coupler (20) which has an outside terminal (7) for said input signal (I_{LO}) having the frequency of the local oscillator, and a pair of terminals called inside terminals (1', 2') for a third signal and its complementary signal ((ILO), I(LOB)) having the frequency of said local oscillator signal, connected to the second pair of input terminals (1, 2) of the ring mixer (17), in which the impedances on said first and second inside terminals are identical relative to ground.

6. A device as claimed in Claim 5, in which the third coupler comprises a field effect differential amplifier stage which receives on the outside terminal (7) the input signal (I_{LO}) having the frequency (LO) of the local oscillator, and a symmetrical field effect transistor buffer stage connecting to the inside terminals (1', 2') with symmetrical identical impedances relative to ground.

7. A device as claimed in one of the Claims 1 to 6, in which the field effect transistors of the mixer (17) are of the MESFET type.

8. A device as claimed in one of the Claims 1 to 6, in which the field effect transistors of the mixer (17) are of the MOSFET type.

9. A device as claimed in one of the Claims 1 to 8, which is monolithically integrated with a semiconductor or semi-insulating substrate of a material of the group III-IV for operation at microwave frequency (MMIC).

10. A device as claimed in Claim 9, for operation with an input signal (I_{RF}) andan output signal (O_{IF}) having neighbouring frequencies which are approximately five to fifteen times the value of the frequency of the signal (I_{LO}) of the local oscillator.

11. A frequency converter apparatus including a device as claimed in one of the Claims 1 to 10.

12. A transmitting and/or receiving apparatus including a device as claimed in one of the Claims 1 to 10.

13. An apparatus as claimed in Claim 12, for microwave transmission.
